# EUROPEAN PATENT SPECIFICATION

(11) **EP 0 246 088 B1**
(45) Date of publication and mention of the grant of the patent: **09.03.1994**
(21) Application number: 87304256.8
(22) Date of filing: 13.05.1987
(51) Int. Cl.: H05K 7/10, H05K 5/00

(54) **ROM mount for paging receiver and others**
ROM-Fassung für Ausrufempfänger und andere
Monture de ROM pour récepteur d'appel et autres

(30) Priority: 16.05.1986 JP 73711/86 U
(43) Date of publication of application: 19.11.1987
(73) Proprietor: NEC CORPORATION, Tokyo (JP)
(72) Inventor: Oyamada, Takashi c/o NEC Corporation, Minato-ku Tokyo 108-01 (JP)
(74) Representative: Orchard, Oliver John

(56) References cited:
- DE-A- 2 145 311
- GB-A- 2 000 381
- US-A- 3 636 413

## Description

The present invention relates to a mount for mounting a read only memory (ROM) on a main carrier member which is installed in a paging receiver and others and, more particularly, to an improvement in the structure of a mount for mounting a ROM on a printed circuit board.

A ROM mount of the kind described generally consists of an open-top box-like casing, a main carrier member installed in the casing, a ROM mounting member provided on that surface of the main carrier member which faces the inward of the casing, and a cover member for closing the open top of the casing. A problem with such a prior art ROM mount is that when one desires to remove a ROM to inspect it, to rewrite its contents and for other purposes, he or she has to remove the main carrier member from the casing and, then, the ROM which is disposed in the inward of the casing, resulting in troublesome manipulation. Moreover, a main carrier member built in a paging receiver and the like is usually loaded not only with a ROM but also with other various kinds of electrical parts in a dense configuration. In such a condition, should any force be applied to the carrier member carelessly during removal of the carrier member from the casing, the carrier member would be bent to cause the electrical parts to interfere with each other and damage, among others, precision parts. For these reasons, there has been keenly demanded a ROM mount structure which allows a ROM to be removed without the need for removing a main carrier member.

In UK patent specification number 2,000,381 there is proposed an arrangement having a casing, a cover and a member carrying electrical parts in which one of the parts is retained in place during use by the cover.

It is an object of the present invention to provide a generally improved ROM mount for, for example, a paging receiver.

A mount for mounting a ROM in one embodiment comprises a box-like casing which is open on one side or top thereof; a flat main carrier member partly machined to have a recess and mounted to the casing such that a circuit pattern surface of the main carrier member, on which a circuit pattern is printed, faces the one end of the casing and a part loading surface of the main carrier member, on which various electrical parts are loaded, faces inward of the casing; and a ROM mounting member fitted on the part loading surface of the main carrier member in alignment with the recess for mounting the ROM, which is inserted in the casing from an open end side of the casing, to connect the ROM to the circuit pattern.

In an embodiment to be described, there is provided a mount for mounting a read only memory (ROM) on a main carrier member which is in a casing of, for example, a paging receiver; the casing having an open top or side. A ROM mounting member, which is positioned on the side of main carrier member facing away from the opening in the casing allows a ROM to be inserted into and removed from the mount through the opening in the casing and through a recess which is formed in the main carrier member.

Embodiments of the invention will now be described, by way of example, with reference to the accompanying drawings, in which:-
Fig. 1 is a vertical section showing a prior art ROM mount;
Fig. 2 is an exploded perspective view of a ROM mount embodying the present invention and a ROM loaded in the ROM mount;
Fig. 3 is an enlarged perspective view of a portion of the ROM mount of Fig. 2 which is adapted to receive the ROM;
Fig. 4 is an exploded perspective view showing in an enlarged scale a ROM mounting member which is included in the ROM mount of Fig. 2; and
Fig. 5 is a fragmentary sectional view showing electrical connection between the ROM mounting member of Fig. 4 and a main carrier member.

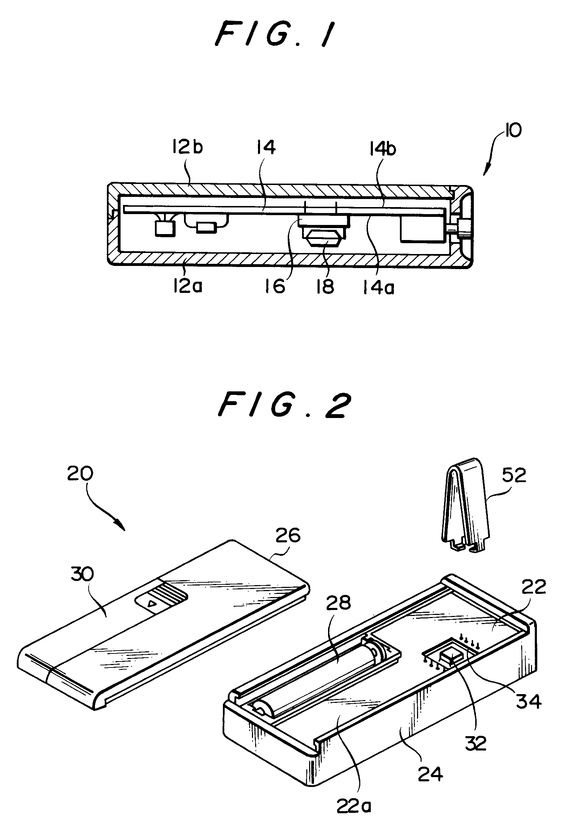

To better understand the present invention, a brief reference will be made to a prior art ROM mount for a paging receiver and others, shown in Fig. 1. The prior art ROM mount, generally 10, includes a casing 12a in which a main carrier member 14 is installed. A ROM mounting member 16 is soldered to a part loading surface 14a of the main carrier member 14, and a ROM 18 is mounted on the carrier member 14 through the ROM mounting member 16. Specifically, the ROM mounting member 16 is fitted on the parts carrying surface 14a of the main carrier member 14 at one side thereof and provided, at the other side, with openings for receiving socket contacts which are adapted for electrical of the ROM 18. The parts carrying surface 14a of the main carrier member 14 which carries the ROM 18 as stated above is located to face the inwardly, that is away from the opening in the casing 12a. The other surface 14b of main carrier member 14 opposite to the surface 14a carrying the parts has a circuit pattern thereon. A cover member 12b is provided for closing the open side of the box-like casing 12a which is adjacent to the circuit pattern surface 14b of the main carrier member 14.

As stated above, in the prior art ROM mount 10, the ROM 18 is mounted on the main carrier member 14 in such a manner as to face inwardly, that is away from the opening in the casing 12a. This is disadvantageous in that it is difficult to remove the ROM 18 which can only be carried out with delicate and troublesome manipulation which may even damage the other electrical parts which share the main carrier member 14 with the ROM 18.

Referring to Figs. 2 to 5, a ROM mount for a paging or other receiver embodying the present invention is shown and generally designated by the reference numeral 20. As shown in Fig. 2, the ROM mount 20 generally comprises a box-like casing 24 which is open at one side thereof, a flat main carrier member 22 mounted in the casing 24, and a cover member 26 for closing the open side of the casing 24. The main carrier member 22 has a circuit pattern surface 22a which is printed with a predetermined circuit pattern. A battery 28 is installed in the casing 24 to power the circuit provided on the circuit pattern surface 22a. Mounted on the other surface of the main carrier member 22 are various electrical parts, not shown, which are interconnected by a circuit pattern. Specifically, while that surface of the main carrier member 22 which is loaded with the various electrical parts faces away from the opening in the casing 24, the circuit pattern surface 22a faces towards the opening, i.e. towards the cover member 26. In Fig. 2, the reference numeral 30 designates a battery cover member.

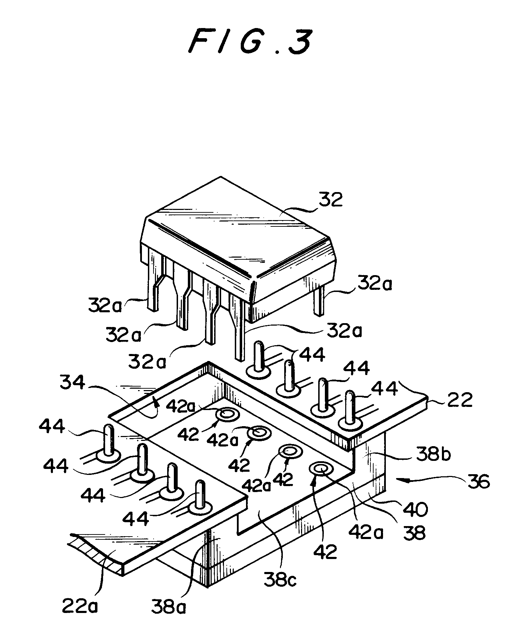

As shown in an enlarged scale in Fig. 3, the main carrier member 22 is notched to have a recess 34 for receiving a ROM 32. A ROM mounting member 36 is fixed to the main carrier member 22 in alignment with the recess 34. The ROM mounting member 36 is made up of a frame 38 and a circuit board 40 which underlies the frame 38, as viewed in Fig. 3. The frame 38 has a generally U-shaped section, i. e. , it includes projections 38a and 38b which are provided at opposite edges of the frame 38, and a flat surface 38c defined between the projections 38a and 38b. The flat surface 38c is provided with socket contacts 42 each having an opening 42a for receiving a respective one of leads 32a of the ROM 32. On the other hand, each of the projections 38a and 38b is provided with a row of pins 44 adapted for connection with the circuit which is printed on the circuit pattern surface 22a of the main carrier member 22. The socket contacts 42 and the pins 44 are paired and electrically interconnected on a one-to-one basis.

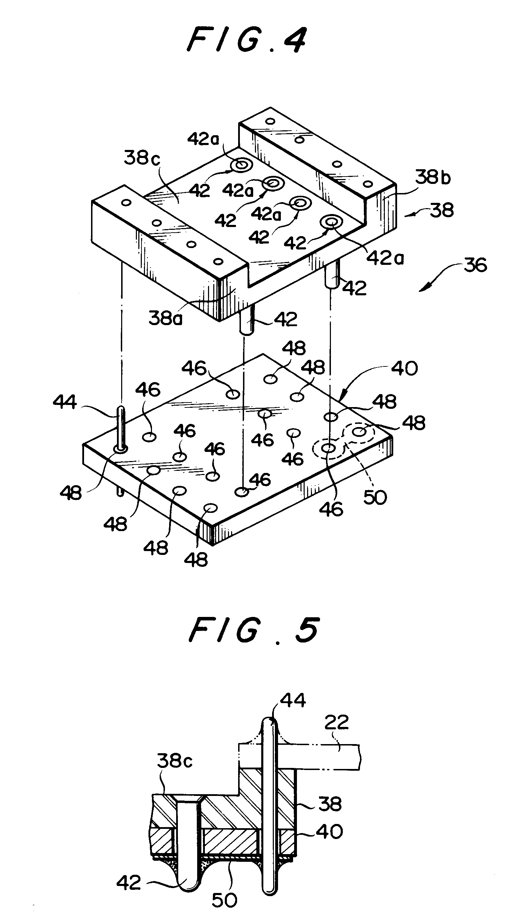

As shown in Fig. 4, the circuit board 40 which forms a part of the ROM mounting member 36 is provided with through openings 46 for receiving the socket contacts 42, and through openings 48 for receiving the pins 44. A conductive pattern 50 is provided on the circuit board 40 to surround those openings 46 and 48 which are assigned to a respective one of the socket contact and pin pairs (only one is shown In the drawing). The socket contacts 42 are individually press-fitted in through openings of the frame 38, then inserted in the openings 46 of the circuit board 40, and then fixed in place by soldering. Likewise, the pins 44 are individually soldered in the openings 48 of the circuit board 40. Each soldering is effected on the conductive patterns 50, whereby the socket contacts 42 and their associated pins 44 are electrically connected to each other (see Fig. 5). As shown in Fig. 3, the tip of each pin 44 projects from the circuit pattern surface 22a of the main carrier member 22, i. e. , on the flat surface 38c side of the frame 38 where the openings 42a of the socket contacts 42 are open.

As shown and described, the ROM mounting member 36 is fixed to the main carrier member 22 on the parts mounting side of the member 22 by soldering the pins 44 (see Fig. 3). The leads 32a of the ROM are individually inserted in the socket contacts 42 from the circuit pattern surface 22a side of the main carrier member 22.

The dimension of the projections 38a and 38b provided on the ROM mounting member 36 is determined according to the height, or thickness, of the ROM 32. Specifically, it is so determined as to avoid the ROM 32 from protruding too far from the circuit pattern, surface 22a of the main carrier member 22 to attach the cover member 26 to the casing 24. When the height of the ROM 32 is relatively low, it may sometimes be needless for both edges of the ROM mounting member 36 to project as shown and described.

In the ROM mount 20 having the above construction, the ROM 32 is inserted into and removed from the circuit pattern surface 22a side of the main carrier member 22, i. e. , from the cover member 26 side. This allows one to remove the ROM 32 for inspection, rewriting and other purposes without removing the main carrier member 22 from the casing 24, thereby making handling more easy and protecting the parts on the member 22 against damage. For the removal of the ROM 32, a tool 52 having a suitable configuration, Fig. 2, is used. It is noteworthy that the ROM mounting member 36 can be handled in the same manner as the prior art one 16 except for the circuit board 40 and pins 44, thereby extending the application of the mount 20.

In summary, it will be seen that a ROM mount in accordance with the present invention allows a ROM to be inserted into and removed from the assembly more easily and without removing a main carrier member from a casing, thus enhancing the ease of manipulation and minimising the risk of damage to various electrical parts on the main carrier member.

Various modifications will become possible for those skilled in the art after receiving the teachings of the present disclosure without departing from the scope of the invention defined in the appended claims.

## Claims

1. An arrangement for mounting a ROM (32), the arrangement including a box-like casing (24) having an opening which may be closed by a cover member (26), a flat carrier member (22) mounted in the casing (24) and having a printed circuit on one surface (22a) facing towards the opening and the opposite surface carrying various electrical parts facing away from the opening, characterised in that there is a recess (34) in the carrier member (22), and in that a ROM mount (36) is fitted on the opposite surface of the carrier member (22) and in alignment with the recess (34), the ROM mount (36) providing electrical connection to the printed circuit on the one surface (22a), whereby the ROM (32) may be removably inserted from the opening in the casing (24) into the recess (34) to make electrical connection with the ROM mount (36) in order to connect the ROM to the printed circuit.

2. An arrangement as claimed in claim 1, characterised in that the cover member (26) is removable from the casing (24).

3. An arrangement as claimed in claim 1, characterised in that the ROM mount (36) includes a support member for supporting the ROM (32), and a connecting member (40) for connecting the ROM (32) supported by the support member to the printed circuit on the one surface (22a).

4. An arrangement as claimed in claim 3, characterised in that the support member constitutes a frame (38), and in that the connecting member (40) is a flat circuit board which is connected to the frame on side thereof facing away from the cover member (26).

5. An arrangement as claimed in claim 4, characterised in that the support member has socket contact openings (42a) formed through the frame, a socket contact (42) being received in a respective one of the socket contact openings (42a) for receiving a respective one of the leads (32a) of the ROM (32), and in that pin openings (48) are formed through the connecting member (40) and paired with the socket contact openings (42a), pins (44) each being inserted in a respective one of the pin openings (48) to be connected to the printed circuit.

6. An arrangement as claimed in claim 5, characterised in that the connecting member (40) has socket contact openings (46) each for receiving a leg portion of a respective one of the socket contacts (42), pin openings (48) each for receiving a respective one of the pins (44), and conductive patterns each for connecting a respective one of pairs of the socket contacts (42) and pins (44).

7. An arrangement as claimed in claim 4, characterised in that the frame (38) is flat.

8. An arrangement as claimed in claim 4, characterised in that support member has projections (38b) at opposite edges, and a flat surface (38c) between the projections (38b).

## Patentansprüche

1. Vorrichtung zum Anordnen eines ROMs (32), wobei die Vorrichtung ein kastenähnliches Gehäuse (24) mit einer Öffnung aufweist, die durch ein Abdeckelement (26) geschlossen werden kann, ein in dem Gehäuse (24) angeordnetes flaches Trägerelement (22), das auf einer Fläche (22a) eine gedruckte Schaltung aufweist, in Richtung der Öffnung zeigt und wobei die gegenüberliegende Fläche verschiedene elektrische Teile trägt, die von der Öffnung weg zeigen, **dadurch gekennzeichnet,** daß in dem Trägerelement (22) eine Vertiefung (34) ist, und daß eine ROM-Fassung (36) auf der gegenüberliegenden Fläche des Trägerelements (22) angebracht ist und mit der Vertiefung (34) ausgerichtet ist, wobei die ROM-Fassung (36) eine elektrische Verbindung mit der gedruckten Schaltung auf der einen Fläche (22a) bereitstellt, wobei das ROM (32) durch die Öffnung in dem Gehäuse (24) in die Vertiefung (34) entfernbar eingesetzt werden kann, um eine elektrische Verbindung mit der ROM-Fassung (36) herzustellen und das ROM mit der gedruckten Schaltung zu verbinden.

2. Vorrichtung nach Anspruch 1, **dadurch gekennzeichnet,** daß das Abdeckelement (26) von dem Gehäuse (24) abnehmbar ist.

3. Vorrichtung nach Anspruch 1, **dadurch gekennzeichnet,** daß die ROM-Fassung (36) ein Trägerelement, um das ROM (32) zu tragen, und ein Verbindungselement (40) aufweist, um das durch das Trägerelement getragene ROM (32) mit der gedruckten Schaltung auf der einen Fläche (22a) zu verbinden.

4. Vorrichtung nach Anspruch 3, **dadurch gekennzeichnet,** daß das Träger element einen Rahmen (38) bildet, und daß das Verbindungselement (40) eine flache Schaltungsplatte ist, die mit dem Rahmen auf dessen einer Seite verbunden ist, die von dem Abdeckelement (26) weg zeigt.

5. Vorrichtung nach Anspruch 4, **dadurch gekennzeichnet,** daß das Träger element durch den Rahmen hindurchgehende Sockelkontaktöffnungen (42a) aufweist, wobei ein Sockelkontakt (42) in einer jeweiligen Sockelkontaktöffnung (42a) aufgenommen wird, um einen jeweiligen Anschluß (32a) des ROMs (32) aufzunehmen, und daß Stiftöffnungen (48) durch das Verbindungselement (40) hindurchgehen und mit den Sockelkontaktöffnungen (42a) zusammenpassen, wobei Stifte (44) jeweils in eine zugehörige Stiftöffnung (48) eingesetzt werden, um mit der gedruckten Schaltung verbunden zu werden.

6. Vorrichtung nach Anspruch 5, **dadurch gekennzeichnet,** daß das Verbindungselement (40) Sockelkontaktöffnungen (46), von denen jede einen Fußabschnitt eines jeweiligen Sockelkontakts (42) aufnimmt, Stiftöffnungen (48), von denen jede jeweils einen der Stifte (44) aufnimmt, und Leitermuster aufweist, von denen jeweils eines ein entsprechendes Paar Sockelkontakte (42) und Stifte (44) miteinander verbindet.

7. Vorrichtung nach Anspruch 4, **dadurch gekennzeichnet,** daß der Rahmen (38) flach ist.

8. Vorrichtung nach Anspruch 4, **dadurch gekennzeichnet,** daß das Trägerelement an gegenüberliegenden Kanten Vorsprünge (38b) und zwischen den Vorsprüngen (38b) eine flache Fläche (38c) aufweist.

## Revendications

1. Agencement pour monter une mémoire morte (32), l'agencement comprenant un boîtier (24) en forme de boîte présentant une ouverture qui peut être fermée par un élément de couvercle (26), un élément de support plat (22) monté dans le boîtier (24) et ayant un circuit imprimé sur une surface (22a) dirigée vers l'ouverture et la surface opposée supportant diverses pièces électriques dirigées dans le sens opposé à la direction de l'ouverture, caractérisé en ce qu'il y a un évidement (34) dans l'élément de support (22), et en ce qu'une monture (36) de mémoire morte est installée sur la surface opposée de l'élément de support (22) et en alignement avec l'évidement (34), la monture (36) de la mémoire morte fournissant une liaison électrique avec le circuit imprimé sur la première surface (22a), d'où il résulte que la mémoire morte (32) peut être insérée de manière amovible dans l'évidement (34) à partir de l'ouverture ménagée dans le boîtier (24) pour réaliser la liaison électrique avec la monture (36) de la mémoire morte de manière à connecter la mémoire morte au circuit imprimé.

2. Agencement selon la revendication 1, caractérisé en ce que l'élément de couvercle (26) peut être enlevé du boîtier (24).

3. Agencement selon la revendication 1, caractérisé en ce que la monture (36) de la mémoire morte comporte un élément de soutien pour supporter la mémoire morte (32), et un élément de connexion (40) pour relier la mémoire morte (32) supportée par l'élément de soutien au circuit imprimé présent sur la première surface (22a).

4. Agencement selon la revendication 3, caractérisé en ce que l'élément de soutien constitue un cadre (38) et en ce que l'élément de connexion (40) est une plaquette plate à circuits, qui est reliée au cadre à son côté orienté en sens opposé à la direction de l'élément de couvercle (26).

5. Agencement selon la revendication 4, caractérisé en ce que l'élément de soutien comporte des ouvertures (42a) pour contact femelle formées dans le cadre, un contact femelle (42) étant reçu dans une ouverture respective parmi les ouvertures (42a) à contact femelle afin de recevoir un conducteur respectif parmi les conducteurs (32a) de la mémoire morte (32), et en ce que des ouvertures (48) pour broche sont ménagées dans l'élément de connexion (40) et apairées avec les ouvertures (42a) pour contact femelle, les broches (44) étant chacune insérées dans une ouverture respective parmi les ouvertures (48) pour broche pour être connectées au circuit imprimé.

6. Agencement selon la revendication 5, caractérisé en ce que l'élément de connexion (40) comporte des ouvertures (46) pour contact femelle, chacune pour recevoir une partie à tige d'un contact respectif parmi les contacts femelles (42), les ouvertures (48) pour broche chacune afin de recevoir une broche respective parmi les broches (44), et des motifs conducteurs chacun pour connecter une paire respective des paires de contacts femelles (42) et des broches (44).

7. Agencement selon la revendication 4, caractérisé en ce que le cadre (38) est plat.

8. Agencement selon la revendication 4, caractérisé en ce que l'élément de soutien comporte des saillies (38a) aux bords opposés, et une surface plate (38c) entre les saillies (38b).
